# EUROPEAN PATENT SPECIFICATION

(11) **EP 0 387 892 B1**
(45) Date of publication and mention of the grant of the patent: **14.06.1995**
(21) Application number: 90104984.1
(22) Date of filing: 16.03.1990
(51) Int. Cl.: H01L 21/316, C23C 16/40, H01L 21/336, G02F 1/136

(54) **Forming an insulation layer, for example in an active matrix device**
Herstellung einer isolierenden Schicht, zum Beispiel in einem aktiven Matrix-Bauelement
Formation d'une couche isolante, par exemple dans un composant actif matriciel

(30) Priority: 17.03.1989 JP 66762/89
(43) Date of publication of application: 19.09.1990
(73) Proprietor: FUJITSU LIMITED, Kawasaki-shi, Kanagawa 211 (JP)
(72) Inventor: Nasu, Yasuhiro, c/o FUJITSU LIMITED, Kawasaki-shi, Kanagawa 211 (JP); Okamoto, Kenji, c/o FUJITSU LIMITED, Kawasaki-shi, Kanagawa 211 (JP); Watanabe, Jun-ichi, c/o FUJITSU LIMITED, Kawasaki-shi, Kanagawa 211 (JP); Endo, Tetsuro, c/o FUJITSU LIMITED, Kawasaki-shi, Kanagawa 211 (JP); Soeda, Shinichi, c/o FUJITSU LIMITED, Kawasaki-shi, Kanagawa 211 (JP)
(74) Representative: Sunderland, James Harry

(56) References cited:
- FR-A- 2 526 622
- US-A- 4 112 148
- US-A- 4 389 973
- APPLIED PHYSICS LETTERS, vol. 51, no. 15, 12th October 1987, pp. 1143-1145, American Institute of Physics, New York, US ; G. OYA et al.: "Growth of alpha-Al203 films by molecular layer epitaxy"
- CONFERENCE RECORD OF THE 1988 INTERNATIONAL DISPLAY RESEARCH CONFERENCE, San Diego, California, 4th-6th October 1988, pp. 155-158, IEEE, New York, US ; E. TAKEDA et al. : "An amorphous Si TFT array with TaOx/SiNx double layered insulator for liquid crystal displays"
- THIN SOLID FILMS, vol. 181, 10th December 1989, pp. 259-266 ; R. LAPPALAINEN et al.: "Ion beam analysis of multilayer structures grown with atomic layer epitaxy (ALE)"

## Description

This invention relates to a method of forming an insulating layer, for example in an active matrix display device.

Thin film transistors (hereinafter referred to as TFTs) are used in an active matrix display device to drive each display element. A TFT has a gate insulation layer formed between a gate electrode and an amorphous silicon semiconductor layer. In order to drive each TFT, gate bus lines and drain bus lines are formed in row and column directions respectively. The gate bus line and the drain bus line must be insulated from each other by an insulation layer at their crossing points. Further, it is necessary to cover and to protect at least a TFT region with a protection layer at the final stage of fabrication of a substrate.

Thus, insulation layers are needed in respect of different portions of the display device structure and are formed at different phases in the course of fabrication of the display device.

In active matrix display devices having TFTs, materials such as indium tin oxide (ITO), amorphous silicon and aluminium are utilised. These materials require process temperatures as low as possible during device fabrication processes. Therefore, insulation layers are preferably deposited at low substrate temperatures which will not result in adverse effects on the grown material. A plasma CVD method is known as a low temperature CVD process and is widely used in manufacturing active matrix display devices.

In forming a TFT, for example, a metal layer is first deposited on a substrate and is patterned, with the result that a gate electrode is formed. A gate insulation layer is next formed thereon. The gate insulation layer is of silicon nitride (SiNₓ) or silicon oxynitride (SiON), and is formed on the substrate by the plasma CVD method, in which the substrate temperature is maintained at around 350°C. Thereafter, an amorphous silicon (a-Si:H) is deposited on the surface of the gate insulation layer using the same plasma CVD apparatus without breaking the vacuum in the apparatus, only source gases being changed. After patterning the amorphous silicon layer, source and drain electrodes are formed thereon, and thus the TFT is formed on the substrate.

In a similar way, an inter-busline insulation layer, which insulates gate bus lines from drain (or source) bus lines, is formed by the plasma CVD method. Sometimes, the inter-busline insulation layer is formed simultaneously with the formation of the gate insulation layer using the same plasma CVD apparatus.

The substrate (first substrate) is sealed together with another, opposing (second) substrate in the final stage of fabrication of the display device, and light-influencing material, such as liquid crystal, is sealed between two substrates. Therefore, another insulation layer is necessary in order to protect amorphous silicon (a-Si:H) portions on the first substrate before the sealing process. The protection (insulation) layer is deposited at least on TFT portions in a similar way.

In order to improve picture quality of active matrix display devices, it has been proposed that auxiliary capacitors be formed in the display device, each arranged at a position corresponding to a display element. In this case, a transparent electrode of a display element connected to the source electrode of a TFT is utilised as a first electrode of an auxiliary capacitor, and either an extended portion of an adjacent gate bus line or a separately formed earth bus line is utilised as a second capacitor electrode, with a capacitor insulation layer being formed between these two electrodes of the auxiliary capacitor.

The four kinds of insulation layer, such as gate insulation layer, inter-bus line insulation layer, protection layer and capacitor insulation layer, which are generally formed by the plasma CVD method at low temperature, suffer the drawback of poor covering capability when deposited on a substrate surface having steps. The insulation layer is of low mechanical strength and easily cracks, resulting in decreased withstand voltage and insulation resistance of the insulation layer.

For replacing the plasma CVD method, other CVD methods, based on different deposition processes, are disclosed in the following patents:-
U.S. Pat. No. 4,058,430 issued on 15th November 1977 to Tuomo Suntola et al., entitled "Method for producing compound thin films";
U.S. Pat. No. 4,486,487 issued on 4th December 1984 to Jarmo I. Skarp, entitled "Combination film, in particular for thin film electroluminescent structures"; and
U.S. Pat. No. 4,389,973 issued on 28th January 1983 to Tuomo S. Santola et al., entitled "Apparatus for performing growth of compound thin films".

The above disclosures relate to the use of the so-called "atomic layer epitaxy" method (the "ALE" method).

The method of U.S. Pat. No. 4,058,430 comprises the steps of subjecting a substrate to the vapour of a first kind of element forming a single atomic layer, and subjecting the thus formed single atomic layer surface to the vapour of a second kind of element which can react with the first element resulting in the formation of a single layer of a compound of first and second elements. These steps are repeated until a desired thickness can be obtained. The method discloses formation of thin films of light-emitting semiconductor or resistance layers.

U.S. Pat. No. 4,486,487 discloses a method of forming a combination film of aluminium oxide and titanium oxide utilising the ALE method.

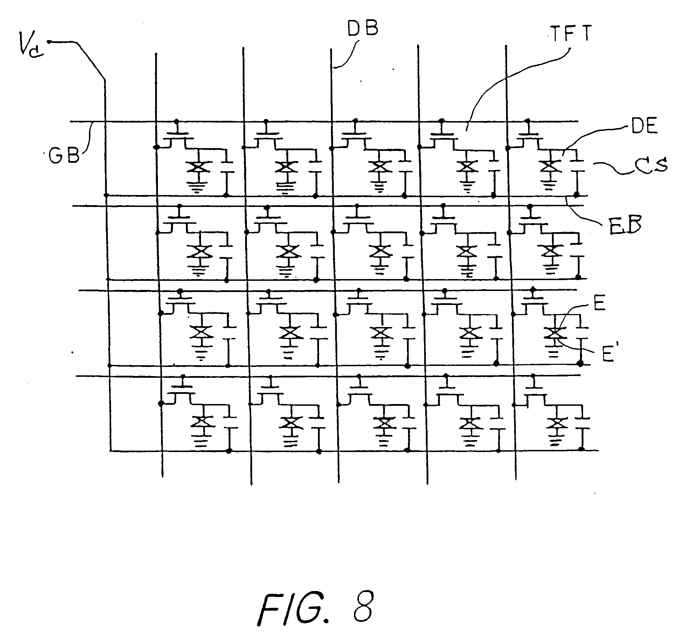

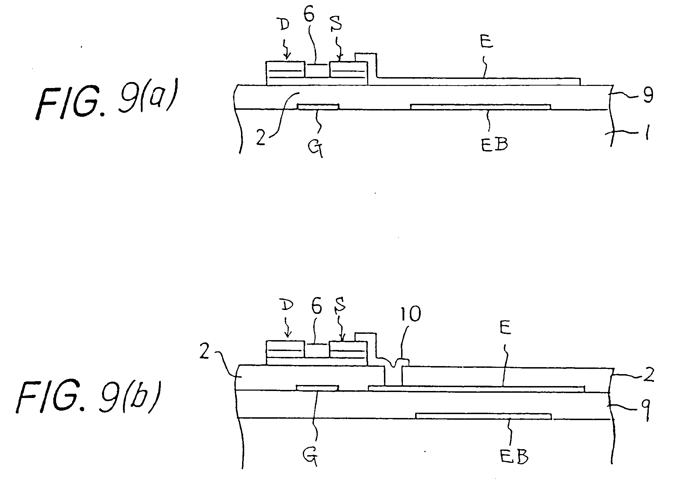

U.S. Pat. No. 4,389,973 discloses a method and an apparatus for forming compound thin films such as tantalum oxide, zinc sulphide and aluminium oxide by the ALE method, emphasising the apparatus used therefor. In the method disclosed, two source gases (one being, for example, Ta₂Cl₅, ZnCl₂ or AlCl₃, and the other being H₂O or H₂S) are alternately pulsed at a substrate. One described apparatus uses mechanical valves to achieve this pulsing. Another described apparatus (e.g. Figs. 8 and 9a to 9c) uses locally fixed streams of reactive vapours provided from sources in opposite vertical flow columns of the body of the apparatus, with walls between the vertical flow columns. Barrier gas streams from tubes in the columns to sweep up reactive vapours between substrates in the apparatus while the substrates are passing the columns. The substrates are rotated so that they pass through the columns and meet each reactive vapour in turn. A further apparatus (Figs. 13 and 14) uses reciprocating movement of the substrate over a fixed array of source openings, carrier openings and exhausts. Diffusion barriers are formed between the substrate and the gas flow array body. Values for reaction zone pressure are given as 0.5 to 5 mb, and 2 mb (100 Pa or the order of 1 Torr) is specifically mentioned. It is said that the apparatus using reciprocating movement of the substrate over a fixed array of openings can operate even at atmospheric pressure.

FR-A-2 526 622 discloses formation of a composite aluminium oxide and titanium oxide film and refers to the ALE method. Use of the composite film as an isolating layer between a luminescent material (ZnS:Mn) and electrode layers (ITO) is mentioned.

Applied Physics Letters, Vol. 51, No. 15, 12th October 1987, pages 1143 to 1145, in an article by Oya et al., entitled "Growth of α-Al₂O₃ films by molecular layer epitaxy" discloses the growth of single crystal α-Al₂O₃ films, by a molecular layer epitaxy method, on single crystal sapphire (α-Al₂O₃) wafers and on single crystal Nb films. The method uses anhydrous AlCl₃ vapour and He 15% O₂ gas mixture as reactants. These two reactants are alternately transported to a chamber where a single crystal sapphire wafer, or a single crystal sapphire substrate with a single crystal Nb film, is held at a temperature from 400 to 800°C. It is indicated that at a temperature above about 600°C, single crystal α-Al₂O₃ films grow, whilst at 500 and 400°C respectively polycrystalline and amorphous films grow. Pressure in the chamber during growth is of the order of 10⁻² Pa (about 10⁻⁵ Torr).

According to the present invention there is provided a method of forming a thin film transistor on a substrate, the transistor comprising a gate electrode, a gate insulation layer, a semiconductor layer, and source and drain electrodes, wherein the gate insulation layer is formed by applying the ALE method in which an insulation layer is formed by subjecting a substrate to two source gases reactive with each other, said method of forming the gate insulation layer comprising:-
providing a reaction chamber having inlets for first and second gases and a barrier gas inlet, and an outlet for exhausting these gases, and means for transferring the substrate between first and second positions within the reaction chamber and for providing flows of the first, second and barrier gases, the inlets for the first and second gases, the barrier gas inlet and the outlet being arranged such that the barrier gas flow separates the first and second gases under a condition of molecular flow and defines the first and second positions, and such that the substrate at the first position is exposed to the first gas and the substrate at the second position is exposed to the second gas under the condition of molecular flow, and comprising the steps of:-
(a) disposing the substrate at the first position and subjecting the substrate to the first gas, being the vapour of a metal compound, organic or inorganic, which can react with H₂O and/or O₂ to form metal oxide, under the condition of molecular flow, the vapour pressure in the reaction chamber being in the range 1 to several tens of milli-Torr (1 millitorr ≡ 0.13 Pa), for a period of time sufficient for the formation of less than or substantially a single atomic layer of metal compound, and
(b) transferring the substrate to the second position and subjecting the surface of the thus formed metal compound layer to the second gas, being H₂O vapour and/or O₂ gas, under the condition of molecular flow, the vapour pressure in the chamber being in the range 1 to several tens of milli-Torr, for a period of time sufficient for the metal compound layer to be replaced by a layer of metal oxide;

steps (a) and (b) being repeated until the insulation layer thus formed reaches a desired thickness.

According to the present invention there is also provided a method of manufacturing an active matrix display device comprising an insulation layer formed on a substrate, the insulation layer having the function of a gate insulation layer of a thin film transistor, or an inter-busline insulation layer, or a protective layer on a thin film transistor, or an insulation layer of an auxiliary capacitor, wherein the insulation layer is formed by applying the ALE method in which an insulation layer is formed by subjecting a substrate to two source gases reactive with each other, said method of forming the insulation layer comprising:-
providing a reaction chamber having inlets for first and second gases and a barrier gas inlet, and an outlet for exhausting these gases, and means for transferring the substrate between first and second positions within the reaction chamber and for providing flows of the first, second and barrier gases, the inlets for the first and second gases, the barrier gas inlet and the outlet being arranged such that the barrier gas flow separates the first and second gases under a condition of molecular flow and defines the first and second positions, and such that the substrate at the first position is exposed to the first gas and the substrate at the second position is exposed to the second gas under the condition of molecular flow, and comprising the steps of:-
(a) disposing the substrate at the first position and subjecting the substrate to the first gas, being the vapour of a metal compound, organic or inorganic, which can react with H₂O and/or O₂ to form metal oxide, under the condition of molecular flow, the vapour pressure in the reaction chamber being in the range 1 to several tens of milli-Torr, for a period of time sufficient for the formation of less than or substantially a single atomic layer of metal compound, and
(b) transferring the substrate to the second position and subjecting the surface of the thus formed metal compound layer to the second gas, being H₂O vapour and/or O₂ gas, under the condition of molecular flow, the vapour pressure in the chamber being in the range 1 to several tens of milli-Torr, for a period of time sufficient for the metal compound layer to be replaced by a layer of metal oxide;

steps (a) and (b) being repeated until the insulation layer thus formed reaches a desired thickness.

An embodiment of the present invention, can provide a method of manufacturing an active matrix display device using an insulation layer which is grown by the ALE method and is not prone to electrical breakdown and has almost no defects such as cracks and pinholes.

In an exemplary active matrix display device, a plurality of display elements are arranged in rows and columns and driven by a plurality of thin film transistors located at respective display element positions. Insulation layers are used for forming the thin film transistors, in which gate insulation layers and protection layers covering the thin film transistor are formed. Further, two groups of bus lines are formed on a substrate in row and column directions respectively, to drive the thin film transistors, and the lines of these two groups are to be insulated from each other, at their crossing points, by an inter-busline insulation layer. In some cases, the active matrix display device may feature an auxiliary capacitor for each display element, the capacitor having a capacitor insulation layer.

Embodiments of the present invention provide methods of forming insulation layers which can be applied, inter alia, for forming any of the above-mentioned insulation layers.

An embodiment of the present invention can provide a method of manufacturing an active matrix display device, wherein a gate insulation layer of thin film transistor of the display device is formed of an insulation layer grown by the ALE method.

An embodiment of the present invention can provide a method of manufacturing an active matrix display device, wherein an inter-busline insulation layer of the display device is formed of an insulation layer grown by the ALE method.

An embodiment of the present invention can provide a method of manufacturing an active matrix display device, wherein a protection layer covering a thin film transistor of the display device is formed of an insulation layer grown by the ALE method.

An embodiment of the present invention can provide a method of manufacturing an active matrix display device, wherein an auxiliary capacitor is formed in respect of each display element and a capacitor insulation layer thereof is formed of an insulation layer grown by the ALE method.

An embodiment of the present invention can provide a method of forming a composite insulation layer comprising layers of different compositions formed by the ALE method.

An embodiment of the present invention can provide a method of forming a thin film transistor, wherein an amorphous silicon is used as an active semiconductor layer and an insulation layer formed by the ALE method is used as a gate insulation layer.

In an embodiment of the present invention an insulation layer is formed by a method comprising a predetermined number of repeated cycles of the steps of subjecting a substrate to the vapour of a metal inorganic/organic compound, which can react with H₂O and/or O₂ to form the metal oxide under molecular flow conditions, for a period of time of a duration providing for the deposition of almost a single atomic layer, and next subjecting the surface of thus formed metal inorganic/organic compound layer to the H₂O vapour and/or O₂ gas under molecular flow conditions, for a period of time of a duration providing for replacement of the metal inorganic/organic compound layer with the metal oxide layer.

When aluminium or titanium compounds are used as the metal inorganic/organic compound, aluminium oxide or titanium oxide layers respectively are grown as insulation layer.

Reference is made, by way of example, to the accompanying drawings, in which:-
Fig. 1 is a partial equivalent circuit diagram of an active matrix display device, for assistance in explaining general concepts included in the device structure;
Fig. 2 is an enlarged top view (view from above to an enlarged scale) of a portion of a first substrate around a TFT forming region of an active matrix display device manufactured in accordance with an embodiment of the present invention;
Fig. 3 is a cross-sectional view taken along line I-I of Fig. 2;
Fig. 4 is a cross-sectional view taken along line II-II of Fig. 2;
Fig. 5 schematically illustrates an apparatus for growing an insulation layer by the ALE method in accordance with an embodiment of the present invention;
Figs. 6(a) and 6(b) are graphs illustrating test results relating to withstand voltage between gate electrode and source/drain electrode of TFTs, wherein Fig. 6(a) shows data obtained for TFTs comprising a gate insulation layer formed in accordance with an embodiment of the present invention and Fig. 6(b) shows data for TFTs produced by previously proposed technology;
Fig. 7 is a graph illustrating test results pertaining to a relationship between vapour pressure inside a reaction chamber and the number of defects per unit area of an insulation layer when gas flow conditions in the ALE apparatus of Fig. 5 are changed;
Fig. 8 is a partial equivalent circuit diagram of an active matrix display device, wherein an auxiliary capacitor is formed at each display element position;
Figs. 9(a) and 9(b) are respective cross-sectional views of substrates having thereon two different types of auxiliary capacitor formed by the ALE method in accordance with embodiments of the present invention; and
Figs. 10(a) to 10(d) are cross-sectional views of a substrate at successive steps in the formation of an auxiliary capacitor and a TFT by the ALE method of an embodiment of the present invention.

In the Figures, the same or similar reference signs designate the same or similar parts.

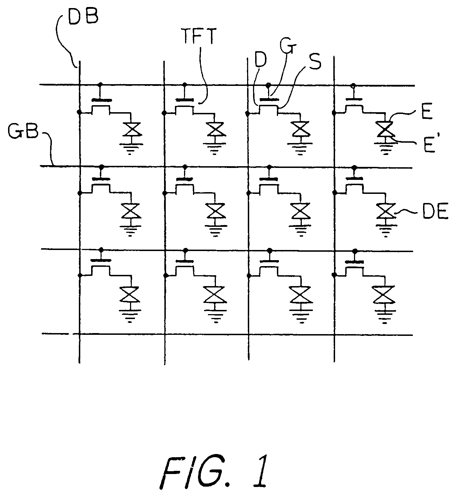

Fig. 1 is a partial equivalent circuit diagram of an active matrix display device, for assistance in explaining general concepts involved in the device structure. A plurality of display elements DE are arranged in rows and columns and each comprises first transparent electrode E formed on a first substrate and a second transparent electrode E′ on a second substrate, with light-influencing material such as liquid crystal therebetween. A plurality of thin film transistors (TFTs) are formed on the first substrate, each at a position corresponding to a display element DE. Each TFT comprises a gate electrode G, a source electrode S and a drain electrode D. A plurality of gate bus lines GB are formed on the first substrate connecting gate electrodes G in the row direction, and a plurality of drain bus lines are also formed on the first substrate connecting drain electrodes D in the column direction, the drain bus lines DB being insulated from the gate bus lines GB.

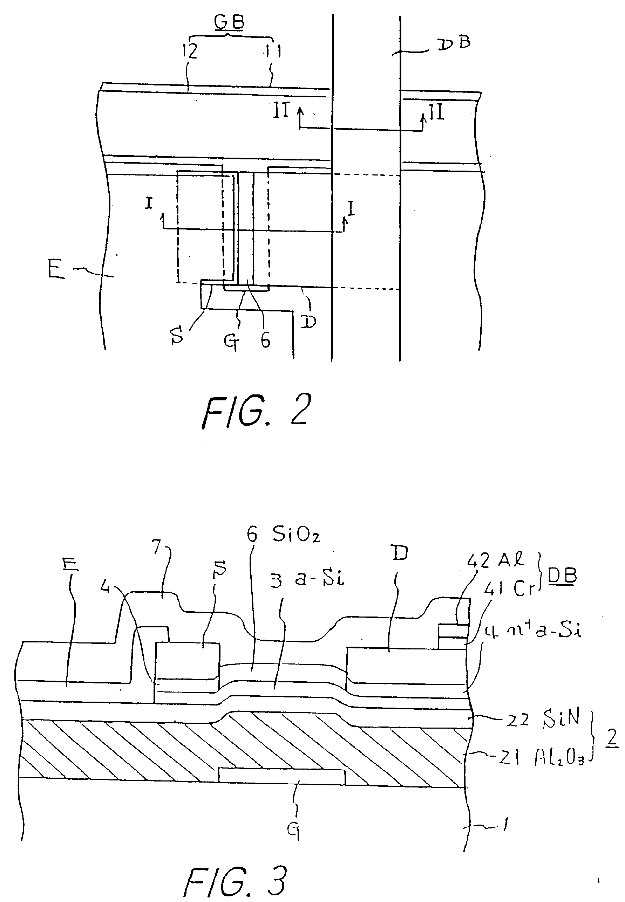

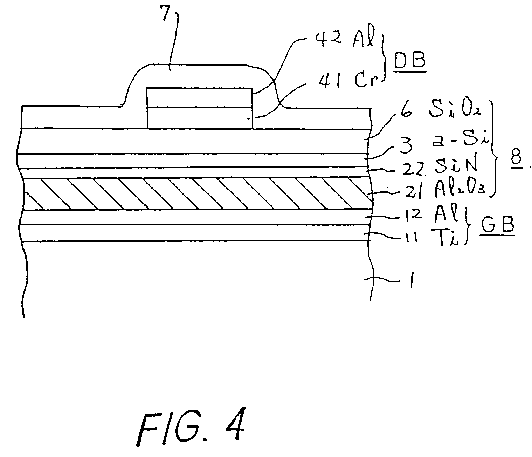

Fig. 2 is an enlarged top view of a first substrate 1, around a TFT forming region, and Figs. 3 and 4 are cross-sectional views taken along lines I-I and II-II respectively of Fig. 2.

A manufacturing method of forming a gate insulation layer and an inter-busline insulation layer in accordance with an embodiment of the present invention will be explained with reference to Figs. 2 to 4.

On the transparent first substrate 1, of an insulating material such as glass, a titanium layer is deposited and patterned, resulting in formation of gate electrodes (see G in Figs. 2 and 3). A lower layer 11 of gate bus lines GB is formed at the same time (see Fig. 4). On the lower layer 11 of the gate bus lines GB, an upper layer 12 of aluminium is further deposited and patterned. The aluminium layer 12 of the gate bus lines may be deposited and patterned before the titanium deposition for gate electrodes G.

Next, an insulation layer 2 including a lower layer 21 and an upper layer 22, is formed on an entire surface of the substrate 1. In the TFT region this insulation layer is used as a gate insulation layer 2 (Fig. 3). At crossing points of the gate bus lines GB with drain bus lines DB (Fig. 4) the insulation layer 2 (21, 22) is used as a constituent part of an inter-busline insulation layer 8. Generally, silicon oxide (SiO₂) has been used as the material of the lower insulation layer 21. However, in accordance with this embodiment of the present invention, the lower insulation layer 21 is of aluminium oxide (alumina, Al₂O₃) and formed by the ALE method, and the upper insulation layer 22 may be either of silicon nitride (SiN) formed by a plasma CVD method, or of aluminium nitride (AlN) formed by the ALE method. However, the use of silicon nitride (SiN) formed by the plasma CVD method may be advantageous because subsequent deposition of amorphous silicon can be performed using the same plasma CVD apparatus without interruption.

Herein, the ALE method used in the embodiment of the present invention will first be explained.

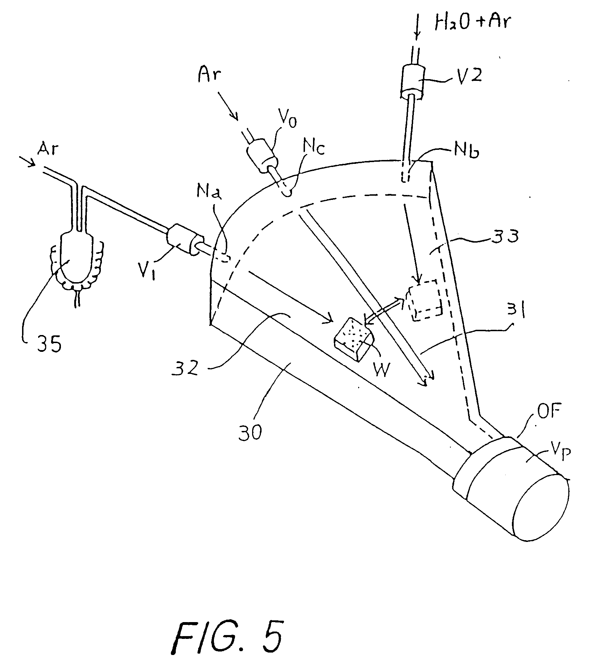

The Al₂O₃ insulation layer 21 deposited by the ALE method can be obtained using an apparatus which is schematically shown in Fig. 5. Hereinafter, apparatus of this type will be called, for convenience, ALE apparatus. The apparatus comprises a reaction chamber 30 having a fan shape, which is exhausted by means of a turbo-molecular pump Vp and the pressure in which is controlled by an orifice valve OF. At a middle portion of an arc-shaped boundary of the chamber, a gas inlet Nc is provided which spouts argon (Ar) gas into the reaction chamber 30. The direction of Ar gas flow is substantially coincident with the centre line of the reaction chamber. The Ar gas flow forms a gas barrier 31 dividing the reaction chamber 30 into two, respective regions on opposite sides of the gas barrier being indicated by 32 and 33. On opposite sides of the gas barrier 31, respective gas inlets Na and Nb are provided. Source gases are supplied to the reaction chamber 30 from these gas inlets Na and Nb. A substrate W, a thin film being deposited thereon, moves back and forth as shown by arrow-headed lines from a first position in region 32 to a second position in region 33 and vice versa. The region 32 is solely under the influence of the gas from the inlet Na, and the region 33 solely under the influence of the gas from the inlet Nb.

A method of forming a thin Al₂O₃ layer using the ALE apparatus explained below.

A substrate is mounted on a stage (not shown) which can move from region 32 to region 33, and is heated to 300°C. The reaction chamber is exhausted to a vacuum degree of about 5 x 10⁻⁷ Torr (1 Torr = 133 Pa) by the turbo-molecular pump Vp. A valve V₀ is opened and Ar gas is made to flow into the reaction chamber through the inlet Nc at a flow rate of about 500 sccm, the flow rate being controlled by a mass flow controller (not shown). Further, the orifice valve OF is controlled to maintain the pressure inside the reaction chamber 30 at about 0.01 Torr.

Next, another valve V₁ is opened and Ar gas is made to flow through a bubbling cylinder 35 of aluminium chloride (AlCl₃) and further through the inlet Na. Because the bubbling cylinder 35 is heated to about 110°C, aluminium chloride vapour is introduced in the region 32.

Next, another valve V₂ is opened and water (H₂O) vapour and/or oxygen (O₂) gas from a bubbling cylinder (not shown) which is maintained at a temperature of 20°C is introduced with argon gas into the region 33 of the reaction chamber 30. The aluminium chloride gas in the region 32 will not mix with the water vapour in the region 33, because the argon gas barrier 31 prevents the mixing of these two gases. The vapour or gas pressure in the reaction chamber 30 during the process is always maintained at about 0.01 Torr.

With the above gas flow conditions provided for the ALE apparatus, the substrate 1 is moved from region 32 to region 33 and then back to region 32 with a period of about 3 seconds. During the first half of the period, an aluminium chloride layer is deposited with a thickness of substantially equal to or less than a single atomic layer, and during the second half of the period, the aluminium chloride (AlCl₃) layer is converted to an aluminium oxide (Al₂O₃) layer due to the following chemical reaction:- $\text{2AlCl₃ + 3H₂O ===> Al₂O₃ + 6HC1.}$

The above movement is repeated about 6000 times, which results in the formation of the thin aluminium oxide layer 21 with a thickness of approx. 4000 Å.

Returning to the explanation based on Figs. 2 to 4, the upper insulation layer 22 of silicon nitride (SiN) is formed on the aluminium oxide layer 21 using a plasma CVD apparatus. The thin silicon nitride layer 22 has a thickness of about 200 Å and is formed with the object of improving interface conditions for an amorphous silicon semiconductor layer 3, which is to be deposited immediately after the formation of the silicon nitride layer 22 using the same plasma CVD apparatus.

The silicon nitride layer 22 and the amorphous silicon layer 3, both layers being formed by the same plasma CVD apparatus without interruption, contribute to improve electrical characteristics due to the interface conditions between two layers and to prevent an abnormal circular growth of amorphous silicon, which may be observed when the amorphous silicon is directly deposited on the aluminium oxide layer 21.

In the illustrated embodiment, the gate insulation layer 2 is a double layer of the aluminium oxide layer 21 and silicon nitride layer 22. This double layer is simultaneously formed on the gate bus line GB of Fig. 4 as constituent layers of an inter-busline insulation layer 8. However, the silicon nitride layer 22 and other layers such as amorphous silicon layer 3 and silicon oxide layer 6 in Fig. 4 are required for the TFT only. Therefore, if the inter-busline insulation layer 8 is formed separately by independent processes, the inter-busline insulation layer may be a single aluminium oxide layer 21.

After forming the silicon nitride layer 22, the amorphous silicon layer 3 and a silicon oxide (SiO₂) layer 6 are continuously deposited on the entire surface of the substrate using the same plasma CVD apparatus. There is no need to take the substrate out of the apparatus during these processes.

In the TFT region, the amorphous silicon layer 3 and silicon oxide layer 6 are patterned, and thereafter, a contact layer 4 of doped amorphous silicon (n⁺ a-Si:H) 4 and a source electrode S and a drain electrode D, both being of titanium, are formed.

In Figs. 3 and 4, a chromium (Cr) layer 41 and an aluminium layer 42 are deposited and patterned, resulting in the connection of a plurality of drain electrodes D in the column direction and forming drain bus lines DB on the silicon oxide layer 6. A display electrode E of thin transparent indium tin oxide (ITO) film is also formed on the silicon nitride layer 22 and patterned with a connection to each source electrode S.

The method of forming an insulation layer in accordance with an embodiment of the present invention can be applied for forming another insulation layer i.e. a protection layer formed on an entire surface of the substrate 1. The protection layer 7 is of aluminium oxide and is formed by the same ALE method. In forming the protection layer 7, in which the TFT is already formed on the substrate, the substrate temperature cannot be raised up to the temperature used in the forming of the Al₂O₃ layer 21 previously applied. Excessively high temperature deteriorates voltage-current characteristics of the TFT and causes a switching voltage of the TFT to increase. Existing methods of forming silicon nitride layer or silicon oxide layer utilise the known plasma CVD method, in which a growth temperature is forcibly reduced to a sufficiently low temperature, and have a drawback in terms of inferior density of the deposited layer which is thus not entirely satisfactory for protecting the TFT.

In this embodiment, the substrate is maintained at a temperature as low as 200°C. In the similar way, the substrate is exposed to the aluminium chloride vapour and the water vapour alternately in the ALE apparatus. This similar process is repeated for 6000 cycles to obtain an aluminium oxide (Al₂O₃) layer of 4000 Å thickness. When the formation of the protection layer 7 is finished, all processes for forming the first substrate 1 are completed.

The substrate of an active matrix display device produced in accordance with the embodiment of the present invention comprises gate insulation layer 2, inter-busline insulation layer 8 and protection layer 7 grown by the ALE method. These insulation layers are of high density and have a close adhesion characteristic to the underlying layer below and provide good coverage over steps in the underlying layer and a high insulation characteristic. Further, the protection layer 7 is formed at a sufficiently low temperature so that a TFT formed on the substrate exhibits no deterioration in characteristics and the switching voltage thereof is very low.

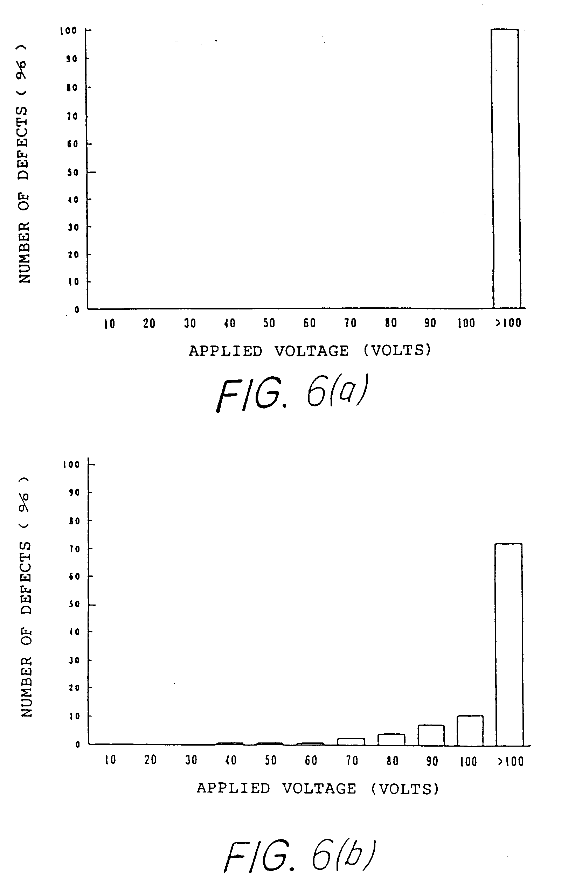

For example, Figs. 6(a) and 6(b) illustrate test results pertaining to withstand voltage between the gate electrodes and source/drain electrodes of TFTs. Fig. 6(a) shows data obtained for TFTs comprising a gate insulation layer produced in accordance with the embodiment of the present invention. Fig. 6(b) shows data for TFTs produced by conventional CVD technology. In both Figures, the abscissa indicates applied voltage and the ordinate indicates the number of gate bus lines GB having a defect, in percentage terms, the defect being caused by breakdown of any one of the TFTs (e.g. the TFT cannot withstand the applied voltage within a specified range) connected to the bus lines in the row direction. The data shows that, when the gate insulation layer is formed in accordance with the embodiment of the present invention, there are no TFTs which are defective in the range corresponding to withstand voltages less than 100 volts.

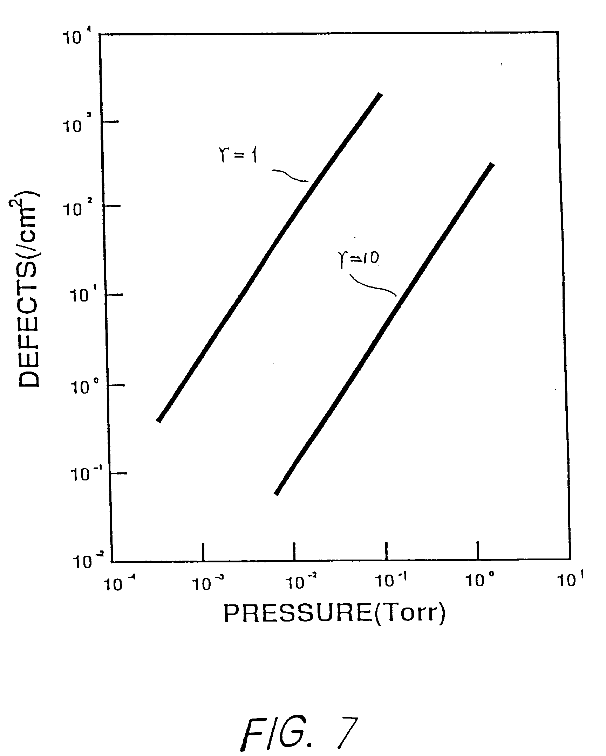

Fig. 7 illustrates a relationship between vapour pressure inside the reaction chamber and the number of defects per unit area of an insulation layer, and the two curves in Fig. 7 were obtained from measurements relating to different values of a parameter r, which is the ratio of flow rate of barrier gas to total flow rate of source gases. As can be seen from Fig. 7, the lower the vapour pressure is, the less the number of defects is. This means that the magnitude of the mean free path of source gas molecules affects the quality of the formed insulation layer. In embodiments of the present invention, vapour flow in the reaction chamber takes place under a condition of molecular flow. Under this condition, the mean free path of the gas molecules is sufficiently long and very few gas molecules flying toward the substrate collide with other molecules and there is very little chance of formation of clusters of gas molecules. As a result, deposition on the substrate is uniform and no nucleus is provided for an abnormal growth of molecules on the substrate. The deposited layer has good adhesion characteristics with regard to the lower underlying layer and is flawless.

When vapour pressure is decreased to 0.01 Torr, the number of defects occurring is three orders of magnitude smaller than the number occurring at a vapour pressure of 1 Torr. However, it is impractical to use a vapour pressure of less than 0.001 Torr, because the growth rate of the deposited layer becomes too low. Therefore, a vapour pressure in the range 1 to several tens of milliTorr is used in the present invention.

Further, Fig. 7 also indicates that the larger the parameter r is, the less the number of defects is. This demonstrates that the barrier gas 31 in Fig. 5 plays an important role in preventing the mixing of two source gases in regions 32 and 33.

In the above-described embodiments, in the formation of the aluminium oxide layer by the ALE method, an aluminium chloride gas (AlCl₃) is utilised as a first source gas. Other inorganic/organic aluminium compound gases such as aluminium bromide (AlBr₃), organoaluminium compounds such as trimethylaluminium [Al(CH₃)₃] and triethylaluminium [Al(C₂H₅)₃], and organoaluminium chlorides such as dimethylaluminium chloride CAl(CH₃)₂Cl] and diethylaluminium chloride [Al(C₂H₅)₂Cl] may be used as source gas.

When the first source gas (AlCl₃) is changed to titanium chloride gas (TiCl₄ or TiCl₃) or titanium bromide (TiBr₄) gas and a substrate is subjected to similar steps as explained with regard to Fig. 5, an insulation layer of titanium oxide (TiO₂) can be grown on the substrate in accordance with an embodiment of the present invention. TiO₂ has a larger dielectric constant than that of Al₂O₃. When a TiO₂ layer is used for the gate insulation layer of a TFT, switching voltage of the TFT can be decreased.

If the ALE growth of Al₂O₃ and the ALE growth of TiO₂ are repeated alternately, in an embodiment of the present invention, each growth being substantially equivalent to or less than a single atomic layer growth, a composite insulation layer of Al₂O₃ and TiO₂ can be obtained, which has a higher dielectric constant than that of Al₂O₃ and a higher insulation characteristic than that of TiO₂. The growth of the composite layer can be effected by changing the source gas from aluminium chloride to titanium chloride gas source alternately, whereby the latter gas source is additionally provided and connected to the valve V₁ in Figure 5.

In the above explanation with regard to formation of the gate insulation layer 2, a silicon nitride layer is referred to as being the upper insulation layer 22. Instead of the silicon nitride layer, an aluminium nitride (AlN) layer can be used as the upper insulation layer in accordance with an embodiment of the present invention. The ALE apparatus of Fig. 5 can be used for growing the AlN layer. When the source gas supplied to the valve V₂ is changed to an ammonia (NH₃) gas source and other gas supply arrangements and processes are the same as previously explained, the aluminium nitride layer can be grown.

It is known that auxiliary capacitors are effective for improving picture quality of an active matrix display device, the auxiliary capacitors being at display element positions and being inserted in parallel with the display elements.

Fig. 8 is an equivalent circuit diagram of a display device with auxiliary capacitors. When Fig. 8 is compared with the equivalent circuit diagram of Fig. 1, it is seen that auxiliary capacitors Cs are added. A first capacitor electrode of such a capacitor is connected to a first transparent display electrode E, and a second capacitor electrode is connected to an earth bus line EB which connects a plurality of second capacitor electrodes in the row direction on a substrate. In a practical design, the first display electrode E is used in common as the first capacitor electrode, and the earth bus line EB is formed separately on the substrate and a portion thereof is used as the second capacitor electrode. The two capacitor electrodes, and a capacitor insulation layer between them, form a capacitor Cs. The earth bus lines EB are separately formed on the substrate, because these lines are to be insulated from gate bus lines GB and drain bus lines DB on the substrate.

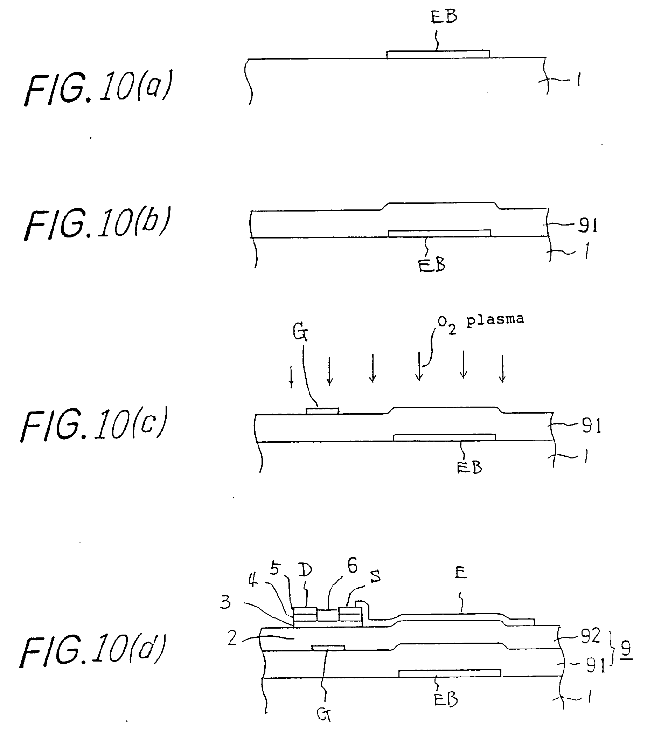

Figs. 9(a), 9(b) and 10(d) are respective cross-sectional views of three different types of substrates with capacitors Cs and TFTs.

In Fig. 9(a), a gate electrode G and a second capacitor electrode EB (earth bus line) are formed directly on a substrate 1. A gate insulation layer 2 is used in common as a capacitor insulation layer 9.

In Fig. 9(b), a second capacitor electrode EB is first formed on a substrate 1, but a gate electrode G is formed on a capacitor insulation layer 9. A transparent display electrode E is also formed on the capacitor insulation layer 9.

In Fig. 10(d), a transparent display electrode E is formed on a double layer 9 of first and second insulation layers 91 and 92. This type eliminates the need for an additional process for forming a connector 10 required in Fig. 9(b) type.

Generally, the second capacitor electrodes EB (earth bus lines) are made of indium tin oxide (ITO), because electrodes EB are required to be transparent. ITO has rather a high resistivity as an electrical conductor and therefore the thickness of the earth bus lines EB is preferably larger in order to reduce the resistance thereof.

With regard to the structure of Fig. 9(a), the earth bus lines EB should be formed with a stripe pattern, each earth bus line running in the row direction and being connected with other bus lines at an end portion thereof. This is because the earth bus line EB cannot cross gate bus lines formed on the same level. Therefore, the electrical resistance of each earth bus line EB cannot be reduced to as low level as may be desirable. On the other hand, earth bus lines of Figs. 9(b) and 10(d) are formed on a lower level, independently, on the substrate. There is no grade crossing with gate bus lines. The earth bus lines EB can be connected in both row and column directions, resulting in sufficient reduction of electrical resistance of all earth bus lines EB.

The capacitor insulation layers 9 used in Figs. 9(a), 9(b) and 10(d) are required to have a good covering effect over steps formed in the underlying layer surface and to have a high density as insulation material and further preferably to have no flaws in the insulation layer.

A method of forming an insulation layer in accordance with an embodiment of the present invention meets these requirements. In forming the capacitor insulation layer 9 of Fig. 9(a), the gate insulation layer 2 (aluminium oxide layer 21 and silicon nitride layer 22) of Fig. 3 can be used without change. The capacitor insulation layer 9 of Fig. 9(b) is of aluminium oxide (Al₂O₃) layer and can be formed utilising the same method as used in forming the aluminium oxide layer 21 of Figs. 3 and 4.

An example of manufacturing processes for providing an auxiliary capacity will be explained with reference to Figs. 10(a) to 10(d).

An earth bus line EB (second capacitor electrode) of ITO is deposited on a substrate 1 and patterned as shown in Fig. 10(a). Utilising the ALE method of an embodiment of the present invention, an aluminium oxide (Al₂O₃) thin layer 91 (capacitor insulation layer) is grown until a thickness of 4000 Å is obtained, as shown in Fig. 10(b). In Fig. 10(c), a gate electrode G of titanium, having a thickness of about 800 Å, and gate bus lines (not shown) are formed on the aluminium oxide layer 91. Thereafter, the surface of the substrate is subjected to an oxygen (O₂) plasma process, which has the effects of removing resist material remainders and oxidising the titanium surface of the gate electrode G.

In Fig. 10(d), a gate insulation layer 2 and a second capacitor insulation layer 92 are formed on the substrate of Fig. 10(c). These insulation layers are provided by a double layer of silicon oxide (SiO₂) about 1000 Å thick and silicon nitride (SiN) about 2000 Å thick. The double insulation layer 92 and the aluminium oxide layer 91 in the capacitor forming region form the capacitor insulation layer 9. An amorphous silicon (a-Si:H) layer 3 about 150 Å thick and a silicon oxide or nitride (SiO₂ or SiN) layer 6 about 1400 Å thick are deposited by a plasma CVD method and patterned. The growth processes of the double insulation layer 2 and 92, amorphous silicon layer 3 and silicon oxide layer 6 can be performed continuously using the same plasma CVD apparatus, during which the substrate does not need to be taken out of the apparatus.

Further, a doped amorphous silicon (n⁺a-Si:H) layer 4, and source and drain electrodes S and D of titanium are deposited and patterned, with the result that a TFT is formed. Finally, a display electrode E of ITO is formed on the insulation layer 9.

The auxiliary capacitor Cs in an active matrix display device embodying the present invention comprises at least an aluminium oxide layer in the capacitor insulation layer 9, the aluminium oxide layer being formed by the ALE method of an embodiment of the present invention. Even when the earth bus line EB has sufficient thickness to cause steep steps, the capacitor insulation layer shows a high insulation characteristic, which reduces defects due to current leakage between capacitor electrodes.

The method can be embodied in capacitor structures of display devices other than those described above.

In the described embodiments, an insulation layer manufactured by the ALE method is used for forming a gate insulation layer, an inter-busline insulation layer, a protection layer and a capacitor insulation layer in an active matrix display device. Embodiments of the invention may be embodied in other specific types without departing from the spirit or essential characteristics of the invention.

The disclosed embodiments have structures such that gate electrode is first formed on a substrate and insulation layer, active semiconductor layer, and source and drain electrodes are subsequently formed in this order (called, conventionally, an inverted staggered type structure); however, embodiments of the present invention may be applied in normal type (staggered type) active matrix display devices, in which the above deposition sequence is inverted.

Further, embodiments of the present invention may be applied to or for or in active matrix display devices for forming gate insulation layers, wherein gate bus lines and data bus lines are separately formed on first and second substrates respectively and each drain electrode is connected to an adjacent gate bus line. This type of the display device is disclosed in U.S. Pat. No. 4,818,981 issued on 4th April 1989 to the present applicant.

An insulation layer provided in accordance with an embodiment of the present invention can be superior in quality and have very few defects. Steps in the underlying surface can be well covered by the formed insulation layer. Further, the insulation layer can be formed at comparatively low temperatures. Active matrix display devices manufactured in accordance with the present invention exhibit a high reliability, a high withstanding voltage, and a high picture quality.

An embodiment of the present invention provides a display device, in which an insulation layer is formed by the ALE method, the insulation layer being any one of a gate insulation layer, an inter-busline insulation layer, a protection layer and auxiliary capacitor insulation layer, for example, comprised in the display device. The method comprises a predetermined number of repeated cycles of the steps of subjecting a substrate to the vapour of a metal inorganic/organic compound, which can react with H₂O and/or O₂ and form the metal oxide, under molecular flow conditions for a duration required for depositing almost a single atomic layer, and next subjecting the surface of thus formed metal inorganic/organic compound layer to the H₂O vapour and/or O₂ gas under molecular flow conditions for a duration required for replacing the metal inorganic/organic compound layer by the metal oxide layer. Subsequent steps, after forming of the insulation layer, include steps for deposition of silicon nitride and amorphous silicon layers using the same plasma CVD apparatus, for example. The molecular flow condition is obtained by maintaining the pressure in a reaction chamber within a range between 1 and several tens of milliTorr.

The present invention provides a method of manufacturing an active matrix display device, comprising first and second substrates forming an enclosure, a plurality of display elements arranged in rows and columns, each display element comprising first and second transparent electrodes formed on inside surfaces of the first and second substrates respectively and light influencing material therebetween, a plurality of thin film transistors formed on the first substrate, the thin film transistor located at each corresponding position of the display elements and having a gate electrode, a gate insulation layer, a semiconductor layer, and source and drain electrodes, and at least gate bus lines formed on the first substrate for driving the display elements through the thin film transistors, the gate bus line connecting the gate electrodes located in the row direction, said manufacturing method comprising the steps of forming the gate insulation layer of the thin film transistor as detailed in claim 5.

The active matrix device may further comprise source/drain bus lines connecting a plurality of source/drain electrodes in the column direction and formed on the first substrate.

The method of forming the thin film transistor may further comprise the following previous and subsequent steps of :-
forming the gate electrode of conductive material on the first substrate before forming said gate insulation layer; and
depositing an amorphous silicon semiconductor layer on said formed gate insulation layer by a plasma CVD method.

The method of forming the thin film transistor may further comprise step (d) after said step (c):-
(d) Depositing a second gate insulation layer of silicon nitride on said gate insulation layer by a plasma CVD method.

The present invention provides a method of manufacturing an active matrix display device, comprising first and second substrates forming an enclosure, a plurality of display elements arranged in rows and columns, each display element comprising first and second transparent electrodes formed on inside surfaces of the first and second substrates respectively and light influencing material therebetween, a plurality of thin film transistors formed on the first substrate, the thin film transistor located at each corresponding position of the display elements and having a gate electrode, a gate insulation layer, a semiconductor layer, and source and drain electrodes, gate bus lines and source/drain bus lines formed on the first substrate for driving the display elements through the thin film transistors, the gate bus line connecting the gate electrodes located in the row direction and the source/drain bus line connecting the source/drain electrodes in the column direction and the gate and source/drain bus lines being insulated from each other by an inter-busline insulation layer at each intersection, said manufacturing method comprising the following steps of forming the inter-busline insulation layer:-
forming the gate bus lines on the first substrate;
depositing the inter-busline insulation layer on the gate bus lines by the method which comprises the predetermined number of repeated cycles of alternate substeps of subjecting the first substrate to the vapour of a metal inorganic/organic compound, which can react with H₂O and/or O₂ and form the metal oxide, for duration of depositing almost a single atomic layer, and of subjecting the surface of thus formed metal inorganic/organic compound layer to the H₂O vapour and/or O₂ gas for duration of replacing the metal inorganic/organic compound layer to the metal oxide layer; and
forming the source/drain bus lines on the inter-busline insulation layer.

This method forming the inter-busline insulation layer may further comprise the step of depositing a second inter-busline insulation layer of silicon nitride on said inter-busline insulation layer by a plasma CVD method before the step of forming the source/drain bus lines.

The depositing step of the inter-busline insulation layer may be a common step for depositing the gate insulation layer.

The present invention provides a method of manufacturing an active matrix display device, comprising first and second substrates forming an enclosure, a plurality of display elements arranged in rows and columns, each display element comprising first and second transparent electrodes on inside surfaces of the first and second substrates respectively and light influencing material therebetween, a plurality of thin film transistors formed on the first substrate, the thin film transistor located at each corresponding position of the display elements and having a gate electrode, a gate insulation layer, a semiconductor layer, and source and drain electrodes, gate bus lines and source/drain bus lines formed on the first substrate for driving the display elements through the thin film transistors, the gate bus line connecting the gate electrodes located in the row direction and the source/drain bus line connecting the source/drain electrodes in the column direction, said device further comprising a protection layer at least on the thin film transistor region, said manufacturing method comprising the following steps of forming the protection layer:-
forming the thin film transistors on the first substrate; and
depositing the protection layer on the thin film transistors by the method which comprises the predetermined number of repeated cycles of alternate substeps of subjecting the first substrate to the vapour of a metal inorganic/organic compound, which can react with H₂O and/or O₂ and form the metal oxide, for duration of depositing almost a single atomic layer, and of subjecting the surface of thus formed metal inorganic/organic compound layer to the H₂O vapour and/or O₂ gas for duration of replacing the metal inorganic/organic compound layer to the metal oxide layer.

The present invention provides a method of manufacturing an active matrix display device, comprising first and second substrates forming an enclosure, a plurality of display elements arranged in rows and columns, each display element comprising first and second transparent electrodes formed on inside surfaces of the first and second substrates respectively and light influencing material therebetween, a plurality of thin film transistors formed on the first substrate, the thin film transistor located at each corresponding position of the display elements and having a gate electrode, a gate insulation layer, a semiconductor layer, and source and drain electrodes, gate bus lines and source/drain bus lines formed on the first substrate for driving the display elements through the thin film transistors, the gate bus line connecting the gate electrodes located in the row direction and the source/drain bus line connecting the source/drain electrodes in the column direction, said display device further comprising an auxiliary capacitor corresponding to each said display element formed by the first transparent electrode and another auxiliary electrode formed on the first substrate, having a capacitor insulation layer therebetween, said manufacturing method comprising the following steps of forming the capacitor insulation layer:-
forming the auxiliary electrode on the first substrate;
depositing the capacitor insulation layer on the auxiliary electrode by the method which comprises the predetermined number of repeated cycles of alternate substeps of subjecting the first substrate to the vapour of a metal inorganic/organic compound, which can react with H₂O and/or O₂ and form the metal oxide, for duration of depositing almost a single atomic layer, and of subjecting the surface of thus formed metal inorganic/organic compound layer to the H₂O vapour and/or O₂ gas for duration of replacing the metal inorganic/organic compound layer to the metal oxide layer; and
forming the first transparent electrode on the capacitor insulation layer.

The present invention thus provides a method of forming a thin insulation layer used in an active matrix display device, the thin insulation layer being used as any one among a gate insulation layer for a thin film transistor, an inter-busline insulation layer, a protective layer on a thin film transistor and an insulation layer for an auxiliary capacitor, said method comprising the predetermined number of repeated cycles of the steps of:-
subjecting a substrate to the vapour of a metal inorganic/organic compound, which can react with H₂O and/or O₂ and form the metal oxide under molecular flow condition, for duration of depositing almost a single atomic layer; and
subjecting the surface of thus formed metal inorganic/organic compound layer to the H₂O vapour and/or O₂ gas under molecular flow condition, for duration of replacing the metal inorganic/organic compound layer to the metal oxide layer.

The metal inorganic/organic compound may be any one or a combination selected from either the group of aluminium chloride, aluminium bromide, trimethylaluminium, triethylaluminium, dimethylaluminium chloride and diethylaluminium chloride for growing aluminium oxide, or the group of titanium chloride and titanium bromide for growing titanium oxide.

The conditions of molecular flow are such that vapour pressure is in the range 1 to several tens of milliTorr.

The present invention provides a method of forming a thin insulation layer in an active matrix display device, the insulation layer being used as any one among a gate insulation layer for a thin film transistor and an insulation layer for an auxiliary capacitor, said method comprising the steps of :-
(a) Subjecting a substrate to the vapour of aluminium chloride under molecular flow condition for duration of depositing almost a single atomic layer;
(b) Subjecting the surface of thus formed aluminium chloride layer to the vapour of H₂O and/or O₂ under molecular flow condition for duration of replacing the aluminium chloride layer to the aluminium oxide layer;
(c) Subjecting the surface of thus formed aluminium oxide layer to the vapour of titanium chloride under molecular flow condition for duration of depositing almost a single atomic layer;
(d) Subjecting the surface of thus formed titanium chloride layer to the vapour of H₂O and/or O₂ under molecular flow condition for duration of replacing the titanium chloride layer to the titanium oxide layer; and
(e) Repeating the steps (a) to (d) for plural cycles until a specified thickness of the insulation layer is grown.

The present invention provides a method of forming a thin film transistor on a substrate comprising a gate electrode, a gate insulation layer, a semiconductor layer, and source and drain electrodes, wherein said method comprises the following steps of forming the gate insulation layer:-
(a) Subjecting the substrate to the vapour of a metal inorganic/organic compound, which can react with H₂O and/or O₂ and form the metal oxide, for duration of depositing almost a single atomic layer;
(b) Subjecting the surface of thus formed metal inorganic/organic compound layer to the H₂O vapour and/or O₂ gas for duration of replacing the metal inorganic/organic compound layer to the metal oxide layer; and
(c) Repeating the steps (a) and (b) alternately for plural cycles until a specified thickness of the metal oxide layer is grown.

This method may further comprise the following steps of:-
(d) Depositing a second gate insulation layer of silicon nitride on said gate insulation layer by a plasma CVD method; and
(e) Depositing the amorphous silicon semiconductor layer on the second insulation layer by the plasma CVD method using the same apparatus in step (d).

The present invention provides an active matrix display device comprising first and second substrates forming an enclosure, a plurality of display elements arranged in rows and columns, each display element comprising first and second transparent electrodes formed on inside surfaces of the first and second substrates respectively and light influencing material therebetween, a plurality of thin film transistors formed on the first substrate, the thin film transistor positioned at each corresponding position of the display elements, and first and second groups of bus lines selectively formed on the substrates and insulated with each other for driving the display elements through the thin film transistors, said thin film transistor comprising:-
a gate electrode;
a gate insulation layer comprising a first insulation layer on the gate electrode and a second insulation layer thereon, the first insulation layer being of aluminium oxide by the ALE deposition, and the second insulation layer being of silicon nitride by a plasma CVD;
an amorphous silicon layer on the second insulation layer by the plasma CVD; and
source and drain electrodes on the amorphous silicon layer.

## Claims

1. A method of forming a thin film transistor on a substrate, the transistor comprising a gate electrode, a gate insulation layer, a semiconductor layer, and source and drain electrodes, wherein the gate insulation layer is formed by applying the ALE method in which an insulation layer is formed by subjecting a substrate to two source gases reactive with each other, said method of forming the gate insulation layer comprising:-
providing a reaction chamber (30) having inlets (Na, Nb) for first and second gases and a barrier gas inlet (Nc), and an outlet (OF, Vp) for exhausting these gases, and means for transferring the substrate (W) between first (32) and second (33) positions within the reaction chamber (30) and for providing flows of the first, second and barrier gases, the inlets (Na, Nb) for the first and second gases, the barrier gas inlet (Nc) and the outlet (OF, W) being arranged such that the barrier gas flow separates the first and second gases under a condition of molecular flow and defines the first (32) and second (33) positions, and such that the substrate (W) at the first position (32) is exposed to the first gas and the substrate (W) at the second position is exposed to the second gas under the condition of molecular flow, and comprising the steps of:-
(a) disposing the substrate (W) at the first position (32) and subjecting the substrate (W) to the first gas, being the vapour of a metal compound, organic or inorganic, which can react with H₂O and/or O₂ to form metal oxide, under the condition of molecular flow, the vapour pressure in the reaction chamber (30) being in the range 1 to several tens of milli-Torr (1 millitorr ≡ 0.13 Pa), for a period of time sufficient for the formation of less than or substantially a single atomic layer of metal compound, and
(b) transferring the substrate (W) to the second position (33) and subjecting the surface of the thus formed metal compound layer to the second gas, being H₂O vapour and/or O₂ gas, under the condition of molecular flow, the vapour pressure in the chamber being in the range 1 to several tens of milli-Torr, for a period of time sufficient for the metal compound layer to be replaced by a layer of metal oxide;
steps (a) and (b) being repeated until the insulation layer thus formed reaches a desired thickness.

2. A method as claimed in claim 1, further comprising the following steps:-
(c) transferring the substrate (W) to the first position (32) and subjecting the substrate to the vapour of a further metal compound, organic or inorganic, which can react with H₂O and/or O₂ to form further metal oxide, under the condition of molecular flow, the vapour pressure in the reaction chamber (30) being in the range 1 to several tens of milli-Torr, for a period of time sufficient for the formation of less than or substantially a single atomic layer of further metal compound, and
(d) transferring the substrate (W) to the second position (33) and subjecting the surface of the further metal compound layer formed in step (c) to the second gas, being H₂O vapour and/or O₂ gas, under the condition of molecular flow, the vapour pressure in the reaction chamber (30) being in the range 1 to several tens of milli-Torr, for a period of time sufficient for the further metal compound layer to be replaced by a layer of further metal oxide;
steps (a), (b), (c) and (d) being repeated until the insulation layer thus formed reaches a desired thickness.

3. A method as claimed in claim 1 or 2, wherein the metal compound used in step (a) is selected either from:-
(i) aluminium chloride, aluminium bromide, trimethylaluminium, triethylaluminium, dimethylaluminiumchloride, diethylaluminium chloride,
in a case in which the metal oxide provided in step (b) is aluminium oxide;
or from:-
(ii) titanium chloride, titanium bromide,
in a case in which the metal oxide provided in step (b) is titanium oxide.

4. A method as claimed in any preceding claim, wherein the thin film transistor comprises a further gate insulation layer, of silicon nitride, deposited on the gate insulation layer of claim 1 by a plasma CVD method, and wherein the semiconductor layer is an amorphous silicon semiconductor layer which is deposited on the further gate insulation layer by the plasma CVD method, using the same apparatus as is used for the deposition of the further gate insulation layer.

5. A method of manufacturing an active matrix display device comprising an insulation layer formed on a substrate, the insulation layer having the function of a gate insulation layer of a thin film transistor, or an inter-busline insulation layer, or a protective layer on a thin film transistor, or an insulation layer of an auxiliary capacitor, wherein the insulation layer is formed by applying the ALE method in which an insulation layer is formed by subjecting a substrate to two source gases reactive with each other, said method of forming the insulation layer comprising:-
providing a reaction chamber (30) having inlets (Na, Nb) for first and second gases and a barrier gas inlet (Nc), and an outlet (OF, Vp) for exhausting these gases, and means for transferring the substrate (W) between first (32) and second (33) positions within the reaction chamber (30) and for providing flows of the first, second and barrier gases, the inlets (Na, Nb) for the first and second gases, the barrier gas inlet (Nc) and the outlet (OF, W) being arranged such that the barrier gas flow separates the first and second gases under a condition of molecular flow and defines the first (32) and second (33) positions, and such that the substrate (W) at the first position (32) is exposed to the first gas and the substrate (W) at the second position is exposed to the second gas under the condition of molecular flow, and comprising the steps of:-
(a) disposing the substrate (W) at the first position (32) and subjecting the substrate (W) to the first gas, being the vapour of a metal compound, organic or inorganic, which can react with H₂O and/or O₂ to form metal oxide, under the condition of molecular flow, the vapour pressure in the reaction chamber (30) being in the range 1 to several tens of milli-Torr (1 millitorr ≡ 0.13 Pa), for a period of time sufficient for the formation of less than or substantially a single atomic layer of metal compound, and
(b) transferring the substrate (W) to the second position (33) and subjecting the surface of the thus formed metal compound layer to the second gas, being H₂O vapour and/or O₂ gas, under the condition of molecular flow, the vapour pressure in the chamber being in the range 1 to several tens of milli-Torr, for a period of time sufficient for the metal compound layer to be replaced by a layer of metal oxide;
steps (a) and (b) being repeated until the insulation layer thus formed reaches a desired thickness.

6. A method as claimed in claim 5, further comprising the following steps:-
(c) transferring the substrate (W) to the first position (32) and subjecting the substrate to the vapour of a further metal compound, organic or inorganic, which can react with H₂O and/or O₂ to form further metal oxide, under the condition of molecular flow, the vapour pressure in the reaction chamber (30) being in the range 1 to several tens of milli-Torr, for a period of time sufficient for the formation of less than or substantially a single atomic layer of further metal compound, and
(d) transferring the substrate (W) to the second position (33) and subjecting the surface of the further metal compound layer formed in step (c) to the second gas, being H₂O vapour and/or O₂ gas, under the condition of molecular flow, the vapour pressure in the reaction chamber (30) being in the range 1 to several tens of milli-Torr, for a period of time sufficient for the further metal compound layer to be replaced by a layer of further metal oxide;
steps (a), (b), (c) and (d) being repeated until the insulation layer thus formed reaches a desired thickness.

7. A method as claimed in claim 5 or 6, wherein the metal compound used in step (a) is selected either from:-
(i) aluminium chloride, aluminium bromide, trimethylaluminium, triethylaluminium, dimethylaluminiumchloride, diethylaluminium chloride,
in a case in which the metal oxide provided in step (b) is aluminium oxide;
or from:-
(ii) titanium chloride, titanium bromide, in a case in which the metal oxide provided in step (b) is titanium oxide.

8. A method as claimed in claim 5, 6 or 7, wherein the active matrix display device has first and second substrates forming an enclosure, a plurality of display elements arranged in rows and columns, each display element comprising first and second transparent electrodes formed on inside surfaces of the first and second substrates respectively and light influencing material therebetween, a plurality of thin film transistors formed on the first substrate at positions corresponding to those of the display elements and having each a gate electrode, a gate insulation layer, a semiconductor layer, and source and drain electrodes, and at least gate bus lines formed on the first substrate for driving the display elements through the thin film transistors, the gate bus line connecting the gate electrodes located in the row direction.

9. A method as claimed in claim 8, wherein the so formed insulation layer is a gate insulation layer of a thin film transistor.

10. A method as claimed in claim 8 or 9, wherein the active matrix display device further comprises source/drain bus lines connecting a plurality of source/drain electrodes in the column direction and formed on the first substrate.

11. A method as claimed in claim 8, 9 or 10 further comprising:-
forming the gate electrode of conductive material on the first substrate before forming said gate insulation layer; and
depositing an amorphous silicon semiconductor layer on said gate insulation layer by a plasma CVD method.

12. A method as claimed in claim 8, 9, 10 or 11, further comprising:-
depositing a second gate insulation layer of silicon nitride on said gate insulation layer by a plasma CVD method.

13. A method as claimed in claim 8, the device further comprising source/drain bus lines formed on the first substrate, the source/drain bus lines connecting source/drain electrodes in the column direction and the gate and source/drain bus lines being insulated from each other by an inter-busline insulation layer at each intersection of such lines, wherein the so formed insulation layer is an inter-busline insulation layer.

14. A method as claimed in claim 13, wherein a second inter-busline insulation layer of silicon nitride is deposited by a plasma CVD method on the so formed insulation layer before the source/drain bus lines are formed.

15. A method as claimed in claim 13 or 14, wherein the so formed insulation layer serves as an inter-busline insulation layer and as a gate insulation layer.

16. A method as claimed in claim 8, the device further comprising a protection layer, at least on a thin film transistor region of the device, wherein the so formed layer is the protection layer.

17. A method as claimed in claim 8, the display device further comprising auxiliary capacitors, corresponding to respective display elements, each formed by a first transparent electrode and another auxiliary electrode formed on the first substrate, having a capacitor insulation layer therebetween, the method comprising forming the auxiliary electrode on the first substrate; providing the so formed insulation layer as the capacitor insulation on the auxiliary electrode; and forming the first transparent electrode on the capacitor insulation layer.

## Patentansprüche

1. Ein Verfahren zum Bilden eines Dünnschichttransistors auf einem Substrat, wobei der Transistor eine Gate-Elektrode, eine Gate-Isolationsschicht, eine Halbleiterschicht sowie Source- und Drain-Elektroden umfaßt, worin die Gate-Isolationsschicht gebildet wird, indem das ALE-Verfahren angewendet wird, bei dem eine Isolationsschicht gebildet wird, indem man ein Substrat zwei Quellengasen aussetzt, die miteinander reagieren, welches Verfahren zur Bildung der Gate-Isolationsschicht umfaßt:
Bereitstellen einer Reaktionskammer (30), die Einlässe (Na, Nb) für erste und zweite Gase und einen Sperrgaseinlaß (Nc) aufweist, und einen Auslaß (OF, Vp) zum Abführen dieser Gase, und Mittel zum Transferieren des Substrates (W) zwischen ersten (32) und zweiten (33) Positionen innerhalb der Reaktionskammer (30) und zum Vorsehen von Strömen aus dem ersten, dem zweiten und dem Sperrgas, wobei die Einlässe (Na, Nb) für das erste und das zweite Gas, der Sperrgaseinlaß (Nc) und der Auslaß (OF, W) derart angeordnet sind, daß der Sperrgasstrom die ersten und zweiten Gase unter einer Bedingung eines Molekularstromes trennt und die erste (32) und zweite (33) Position definiert, und derart, daß das Substrat (W) bei der ersten Position (32) dem ersten Gas ausgesetzt ist und das Substrat (W) bei der zweiten Position dem zweiten Gas unter der Bedingung des Molekularstromes ausgesetzt ist, und das die Schritte umfaßt:
(a) Anordnen des Substrates (W) bei der ersten Position (32) und Aussetzen des Substrates (W) dem ersten Gas, das ein Dampf aus einer Metallverbindung ist, organisch oder anorganisch, die mit H₂O und/oder O₂ reagieren kann, um Metalloxid zu bilden, unter der Bedingung des Molekularstromes, wobei der Dampfdruck in der Reaktionskammer (30) sich in dem Bereich von 1 bis einigen Zehn milli-Torr bewegt (1 milli-Torr = 0,13 Pa), für eine Zeitperiode, die für die Bildung von im wesentlichen einer Einzelatomschicht der Metallverbindung oder weniger ausreichend ist, und
(b) Transferieren des Substrates (W) zu der zweiten Position (33) und Aussetzen der Oberfläche der derart gebildeten Metallverbindungsschicht dem zweiten Gas, das H₂O-Dampf und/oder O₂-Gas ist, unter der Bedingung des Molekularstromes, wobei der Dampfdruck in der Kammer sich in dem Bereich von 1 bis einigen Zehn milli-Torr bewegt, für eine Zeitperiode, die ausreichend ist, um die Metallverbindungsschicht durch die Schicht aus Metalloxid zu ersetzen;
wobei die Schritte (a) und (b) wiederholt werden, bis die derart gebildete Isolationsschicht die gewünschte Dicke erreicht.

2. Ein Verfahren nach Anspruch 1, das desweiteren die folgenden Schritte umfaßt:
(c) Transferieren des Substrates (W) zu der ersten Position (32) und Aussetzen des Substrates dem Dampf einer weiteren Metallverbindung, organisch oder anorganisch, die mit H₂O und/oder O₂ reagieren kann, um ein weiteres Metalloxid zu bilden, unter der Bedingung des Molekularstromes, wobei der Dampfdruck in der Reaktionskammer (30) sich in dem Bereich zwischen 1 und einigen Zehn milli-Torr bewegt, für eine Zeitperiode, die für die Bildung einer Einzelatomschicht aus der weiteren Metallverbindung oder weniger ausreichend ist, und
(d) Transferieren des Substrates zu der zweiten Position (33) und Aussetzen der Oberfläche der weiteren Metallverbindungsschicht, die in dem Schritt (c) gebildet worden ist, dem zweiten Gas, das H₂O-Dampf und/oder O₂-Gas ist, unter der Bedingung des Molekularstroms, wobei der Dampfdruck in der Reaktionskammer (30) sich in dem Bereich zwischen einem und einigen Zehn milli-Torr bewegt, für eine Zeitperiode, die ausreichend ist, um die weitere Metallverbindungsschicht durch eine Schicht des weiteren Metalloxids zu ersetzen;
wobei die Schritte (a), (b), (c) und (d) wiederholt werden, bis die derart gebildete Isolationsschicht eine gewünschte Dicke erreicht.

3. Ein Verfahren nach Anspruch 1 oder 2, worin die in dem Schritt (a) verwendete Metallverbindung ausgewählt wird aus:
(i) Aluminiumchlorid, Aluminiumbromid, Trimethylaluminium, Triethylaluminium, Dimethylaluminiumchlorid, Diethylaluminiumchlorid,
in einem Fall, in dem das im Schritt (b) bereitgestellte Metalloxid Aluminiumoxid ist; oder aus:
(ii) Titanchlorid, Titanbromid, in einem Fall, in dem das im Schritt (b) bereitgestellte Metalloxid Titanoxid ist.

4. Ein Verfahren nach einem der vorigen Ansprüche, worin der Dünnschichttransistor eine weitere Gate-Isolationsschicht aus Siliziumnitrid umfaßt, die auf der Gate-Isolationsschicht aus Anspruch 1 mittels eines Plasma-CVD-Verfahrens abgeschieden worden ist und worin die Halbleiterschicht eine amorphe Siliziumhalbleiterschicht ist, die auf der weiteren Gate-Isolationsschicht mittels dem Plasma-CVD-Verfahren abgeschieden worden ist, unter Verwendung der gleichen Vorrichtung, die für die Abscheidung der weiteren Gate-Isolationsschicht verwendet worden ist.

5. Ein Verfahren zur Herstellung einer Anzeigeneinrichtung mit aktiver Matrix, die eine auf einem Substrat ausgebildete Isolationsschicht umfaßt, wobei die Isolationsschicht die Funktion einer Gate-Isolationsschicht eines Dünnschichttransistors oder einer Inter-Busleitungsisolationsschicht oder einer Schutzschicht auf einem Dünnschichttransistor oder einer Isolationsschicht für einen Hilfskondensators hat, worin die Isolationsschicht gebildet wird, indem das ALE-Verfahren verwendet wird, in dem eine Isolationsschicht gebildet wird, indem man ein Substrat zwei Quellengasen aussetzt, die miteinander reagieren, wobei das genannte Verfahren zur Bildung der Isolationsschicht umfaßt:
Bereitstellen einer Reaktionskammer (30), die Einlässe (Na, Nb) für erste und zweite Gase sowie einen Sperrgaseinlaß (Nc) aufweist, und einen Auslaß (OF, Vp), um diese Gase abzuführen, und Mittel zum Transferieren des Substrates (W) zwischen ersten (32) und zweiten (33) Positionen innerhalb der Reaktionskammer (30) und zum Bereitstellen von Strömen aus dem ersten, dem zweiten und dem Sperrgas, wobei die Einlässe (Na, Nb) für die ersten und zweiten Gase, der Sperrgaseinlaß (Nc) und der Auslaß (OF, W) derart angeordnet sind, daß der Sperrgasfluß die ersten und zweiten Gase unter einer Bedingung eines Molekularstromes trennt und die erste (32) und die zweite (33) Position definiert, und derart, daß das Substrat (W) bei der ersten Position (32) dem ersten Gas ausgesetzt ist und das Substrat (W) bei der zweiten Position dem zweiten Gas unter der Bedingung des Molekularstromes ausgesetzt ist, und das die Schritte umfaßt:
(a) Anordnen des Substrates (W) bei der ersten Position (32) und Aussetzen des Substrates (W) dem ersten Gas, das ein Dampf aus einer Metallverbindung ist, organisch oder anorganisch, die mit H₂O und/oder O₂ reagieren kann, um Metalloxid zu bilden, unter der Bedingung des Molekularstromes, wobei der Dampfdruck in der Reaktionskammer (30) sich in dem Bereich zwischen 1 und einigen Zehn milli-Torr bewegt (1 milli-Torr = 0,013 Pa), für eine Zeitperiode, die für die Bildung von im wesentlichen einer Einzelatomschicht der Metallverbindung oder weniger ausreichend ist, und
(b) Transferieren des Substrates (W) zu der zweiten Position (33) und Aussetzen der Oberfläche der derart gebildeten Metallverbindungsschicht dem zweiten Gas, das ein H₂O-Dampf und/oder O₂-Gas ist, unter der Bedingung des Molekularstromes, wobei der Dampfdruck in der Kammer sich in dem Bereich zwischen 1 und einigen Zehn milli-Torr bewegt, für eine Zeitperiode, die ausreichend ist, um die Metallverbindungsschicht durch eine Schicht aus Metalloxid zu ersetzen;
wobei die Schritte (a) und (b) wiederholt werden, bis die derart gebildete Isolationsschicht eine gewünschte Dicke erreicht.

6. Ein Verfahren nach Anspruch 5, das desweiteren die folgenden Schritte umfaßt:
(c) Transferierene des Substrates (W) zu der ersten Position (32) und Aussetzen des Substrates dem Dampf einer weiteren Metallverbindung, organisch oder anorganisch, die mit H₂O und/oder O₂ reagieren kann, um ein weiteres Metalloxid zu bilden, unter der Bedingung des Molekularstromes, wobei der Dampfdruck in der Reaktionskammer (30) sich in dem Bereich zwischen 1 und einigen Zehn milli-Torr bewegt, für eine Zeitperiode, die für die Bildung von im wesentlichen einer Einzelatomschicht der weiteren Metallverbindung oder weniger ausreichend ist; und
(d) Transferierenl des Substrates (W) zu der zweiten Position (33) und Aussetzen der Oberfläche der im Schritt (c) gebildeten weiteren Metallverbindungsschicht dem zweiten Gas, das H₂O-Dampf oder O₂-Gas ist, unter der Bedingung des Molekularstromes, wobei der Dampfdruck in der Reaktionskammer (30) sich in dem Bereich zwischen 1 und einigen Zehn milli-Torr bewegt, für eine Zeitperiode, die ausreichend ist, um die weitere Metallverbindungsschicht durch eine Schicht aus dem weiteren Metalloxid zu ersetzen;
wobei die Schritte (a), (b), (c) und (d) wiederholt werden, bis die derart gebildete Isolationsschicht eine gewünschte Dicke erreicht.

7. Ein Verfahren nach Anspruch 5 oder 6, worin die in dem Schritt (a) verwendete Metallverbindung ausgewählt wird aus:
(i) Aluminiumchlorid, Aluminiumbromid, Trimethylaluminium, Triethylaluminium, Dimethylaluminiumchlorid, Diethylaluminiumchlorid,
in einem Fall, in dem das im Schritt (b) bereitgestellte Metalloxid Aluminiumoxid ist; oder aus:
(ii) Titanchlorid, Titanbromid, in einem Fall, in dem das im Schritt (b) bereitgestellte Metalloxid Titanoxid ist.

8. Ein Verfahren nach Anspruch 5, 6 oder 7, worin die Anzeigeneinrichtung mit aktiver Matrix erste und zweite Substrate aufweist, die eine Hülle bilden, eine Mehrzahl von Anzeigenelementen in Zeilen und Spalten angeordnet sind, wobei jedes Anzeigenelement erste und zweite transparente Elektroden umfaßt, die jeweils auf inneren Oberflächen der ersten und zweiten Substrate angeordnet sind, mit einem lichtbeeinflussenden Material dazwischen, eine Mehrzahl von Dünnschichttransistoren, die auf dem ersten Substrat bei Positionen gebildet sind, die denen der Anzeigenelemente entsprechen und die jeweils eine Gate-Elektrode, eine Gate-Isolationsschicht, eine Halbleiterschicht und Source- und Drain-Elektroden aufweisen, und wenigstens Gate-Busleitungen, die auf dem ersten Substrat ausgebildet sind, um die Anzeigenelemente durch die Dünnschichttransistoren zu treiben, wobei die Gate-Busleitungen die Gate-Elektroden verbinden, die in Zeilenrichtung angeordnet sind.

9. Ein Verfahren nach Anspruch 8, worin die derart gebildete Isolationsschicht eine Gate-Isolationsschicht eines Dünnschichttransistors ist.

10. Ein Verfahren nach Anspruch 8 oder 9, worin die Anzeigeneinrichtung mit aktiver Matrix desweiteren Source-/Drain-Busleitungen umfaßt, die eine Mehrzahl von Source-/Drain-Elektroden in Spaltenrichtung verbinden und die auf dem ersten Substrat ausgebildet sind.

11. Das Verfahren nach Anspruch 8, 9 oder 10, das desweiteren umfaßt:
Bilden der Gate-Elektroden aus leitendem Material auf dem ersten Substrat vor dem Ausbilden der genannte Gate-Isolationsschicht; und
Abscheiden einer amorphen Siliziumhalbleiterschicht auf der genannten Gate-Isolationsschicht mittels eines Plasma-CVD-Verfahrens.

12. Ein Verfahren nach Anspruch 8, 9, 10 oder 11, das desweiteren umfaßt:
Abscheiden einer zweiten Gate-Isolationsschicht aus Siliziumnitrid auf der genannten Gate-Isolationsschicht mittels eines Plasma-CVD-Verfahrens.

13. Ein Verfahren nach Anspruch 8, worin die Einrichtung desweiteren Source-/Drain-Busleitungen umfaßt, die auf dem ersten Substrat ausgebildet sind, wobei die Source-/Drain-Busleitungen Source-/Drain-Elektroden in Spaltenrichtung verbinden und die Gate- und Source-/Drain-Busleitungen voneinander durch eine Inter-Busleitungsisolationsschicht bei jedem Schnittpunkt derartiger Linien isoliert sind, worin die so gebildete Isolationsschicht eine Inter-Busleitungsisolationsschicht ist.

14. Verfahren nach Anspruch 13, worin eine zweite Inter-Busleitungsisolationsschicht aus Siliziumnitrid mittels eines Plasma-CVD-Verfahrens auf der derart gebildeten Isolationsschicht abgeschieden wird, bevor die Source-/Drain-Busleitungen gebildet werden.

15. Ein Verfahren nach Anspruch 13 oder 14, worin die so gebildete Isolationsschicht als eine Inter-Busleitungsisolationsschicht und als eine Gate-Isolationsschicht dient.

16. Ein Verfahren nach Anspruch 8, worin die Einrichtung desweiteren eine Schutzschicht auf wenigstens einem Dünnschichttransistorbereich der Einrichtung umfaßt, worin die so gebildete Schicht die Schutzschicht ist.

17. Ein Verfahren nach Anspruch 8, worin die Anzeigeneinrichtung desweiteren Hilfskondensatoren umfaßt, die jeweiligen Anzeigenelementen entsprechen, wobei ein jeder durch eine erste transparente Elektrode und eine andere Hilfselektrode gebildet wird, die auf dem ersten Substrat gebildet wird, die eine Kondensatorisolationsschicht zwischen sich aufweisen, wobei das Verfahren das Bilden der Hilfselektrode auf dem ersten Substrat umfaßt; das Bereitstellen der so gebildeten Isolationsschicht als Kondensatorisolation auf der Hilfselektrode; und das Bilden der ersten transparenten Elektrode auf der Kondensatorisolationsschicht.

## Revendications

1. Procédé de formation d'un transistor à film mince sur un substrat, le transistor comprenant une électrode de grille, une couche d'isolation de grille, une couche semiconductrice et des électrodes de source et de drain, dans lequel la couche d'isolation de grille est formée en appliquant un procédé ALE dans lequel une couche d'isolation est formée en soumettant un substrat à deux gaz source qui réagissent l'un avec l'autre, ledit procédé de formation de la couche d'isolation de grille comprenant :
la fourniture d'une chambre de réaction (30) comportant des entrées (Na, Nb) pour des premier et second gaz, une entrée de gaz barrière (Nc) et une sortie (OF, Vp) pour évacuer ces gaz, et d'un moyen pour transférer le substrat (W) entre des première (32) et seconde (33) positions à l'intérieur de la chambre de réaction (30) et pour produire un écoulement des premier, second et troisième gaz barrière, les entrées (Na, Nb) pour les premier et second gaz, l'entrée de gaz barrière (Nc) et la sortie (OF, W) étant agencées de telle sorte que l'écoulement de gaz barrière sépare les premier et second gaz moyennant une condition d'écoulement moléculaire et qu'il définisse les première (32) et seconde (33) positions, de telle sorte que le substrat (W), à la première position (32), soit exposé au premier gaz et que le substrat (W), à la seconde position, soit exposé au second gaz moyennant la condition d'écoulement moléculaire, et comprenant les étapes de:
(a) positionnement du substrat (W) dans la première position (32) et soumission du substrat (W) au premier gaz qui est la vapeur d'un composé métallique organique ou inorganique qui peut réagir avec du H₂O et/ou de l'O₂ pour former un oxyde métallique à la condition d'écoulement moléculaire, la pression de vapeur dans la chambre de réaction (30) étant dans la plage de 1 à plusieurs dizaines de milli-Torr (1 millibar = 0,13 Pa), pendant une période temporelle suffisante pour la formation de moins qu'une unique couche atomique de composé métallique ou de sensiblement celle-ci; et
(b) transfert du substrat (W) dans la seconde position (33) et soumission de la surface de la couche de composé métallique ainsi formée au second gaz qui est de la vapeur de H₂O et/ou de gaz O₂ à la condition d'écoulement moléculaire, la pression de vapeur dans la chambre étant dans la plage de 1 à plusieurs dizaines de milli-Torr, pendant une période temporelle suffisante pour que la couche de composé métallique soit remplacée par une couche d'oxyde métallique ;
les étapes (a) et (b) étant répétées jusqu'à ce que la couche d'isolation ainsi formée atteigne une épaisseur souhaitée.

2. Procédé selon la revendication 1, comprenant en outre les étapes suivantes:
(c) transfert du substrat (W) dans la première position (32) et soumission du substrat à la vapeur d'un autre composé métallique, organique ou inorganique, qui peut réagir avec du H₂O et/ou de l'O₂ pour former un autre oxyde métallique à la condition d'écoulement moléculaire, la pression de vapeur dans la chambre de réaction (30) étant dans la plage de 1 à plusieurs dizaines de milli-Torr, pendant une période temporelle suffisante pour la formation de moins qu'une unique couche atomique du composé métallique supplémentaire ou de sensiblement celle-ci et
(d) transfert du substrat (W) dans la seconde position (33) et soumission de la surface de la couche de composé métallique supplémentaire formée au niveau de l'étape (c) au second gaz qui est de la vapeur de H₂O et/ou de gaz O₂ moyennant la condition d'écoulement moléculaire, la pression de vapeur dans la chambre de réaction (30) étant dans la plage de 1 à plusieurs dizaines de milli-Torr pendant une période temporelle qui suffit pour que la couche de composé métallique supplémentaire soit remplacée par une couche d'oxyde métallique supplémentaire ;
les étapes (a), (b), (c) et (d) étant répétées jusqu'à ce que la couche d'isolation ainsi formée atteigne une épaisseur souhaitée.

3. Procédé selon la revendication 1 ou 2, dans lequel le composé métallique utilisé au niveau de l'étape (a) est choisi de manière à être un élément pris parmi:
(i) le chlorure d'aluminium, le bromure d'aluminium, le triméthylaluminium, le triéthylaluminium, le chlorure de diméthylaluminium, le chlorure de diéthylaluminium dans le cas où l'oxyde métallique prévu au niveau de l'étape (b) est de l'oxyde d'aluminium
ou parmi:
(ii) le chlorure de titane, le bromure de titane dans le cas où l'oxyde métallique prévu au niveau de l'étape (b) est de l'oxyde de titane.

4. Procédé selon l'une quelconque des revendications précédentes, dans lequel le transistor à film mince comprend une couche d'isolation de grille supplémentaire en nitrure de silicium déposée sur la couche d'isolation de grille de la revendication 1 au moyen d'un procédé de dépôt chimique en phase vapeur assisté plasma et dans lequel la couche semiconductrice est une couche semiconductrice en silicium amorphe qui est déposée sur la couche d'isolation de grille supplémentaire au moyen du procédé CVD plasma en utilisant le même appareil qu'utilisé pour le dépôt de la couche d'isolation de grille supplémentaire.

5. Procédé de fabrication d'un dispositif d'affichage matriciel actif comprenant une couche d'isolation formée sur un substrat, la couche d'isolation ayant la fonction d'une couche d'isolation de grille d'un transistor à film mince ou d'une couche d'isolation interligne de bus, ou d'une couche de protection sur un transistor à film mince, ou d'une couche d'isolation d'une capacité auxiliaire, dans lequel la couche d'isolation est formée en appliquant le procédé ALE dans lequel une couche d'isolation est formée en soumettant un substrat à deux gaz source qui réagissent l'un avec l'autre, ledit procédé de formation de la couche d'isolation comprenant :
la fourniture d'une chambre de réaction (30) comportant des entrées (Na, Nb) pour des premier et second gaz, une entrée de gaz barrière (Nc) et une sortie (OF, Vp) pour évacuer ces gaz, et d'un moyen pour transférer le substrat (W) entre des première (32) et seconde (33) positions à l'intérieur de la chambre de réaction (30) et pour produire un écoulement des premier, second et troisième gaz barrière, les entrées (Na, Nb) pour les premier et second gaz, I'entrée de gaz barrière (Nc) et la sortie (OF, W) étant agencées de telle sorte que l'écoulement de gaz barrière sépare les premier et second gaz moyennant une condition d'écoulement moléculaire et qu'il définisse les première (32) et seconde (33) positions, de telle sorte que le substrat (W), à la première position (32), soit exposé au premier gaz et que le substrat (W), à la seconde position, soit exposé au second gaz moyennant la condition d'écoulement moléculaire, et comprenant les étapes de:
(a) positionnement du substrat (W) dans la première position (32) et soumission du substrat (W) au premier gaz qui est la vapeur d'un composé métallique organique ou inorganique qui peut réagir avec du H₂O et/ou de l'O₂ pour former un oxyde métallique à la condition d'écoulement moléculaire, la pression de vapeur dans la chambre de réaction (30) étant dans la plage de 1 à plusieurs dizaines de milli-Torr (1 millibar = 0,13 Pa), pendant une période temporelle suffisante pour la formation de moins qu'une unique couche atomique de composé métallique ou de sensiblement celle-ci; et
(b) transfert du substrat (W) dans la seconde position (33) et soumission de la surface de la couche de composé métallique ainsi formée au second gaz qui est de la vapeur de H₂O et/ou de gaz O₂ à la condition d'écoulement moléculaire, la pression de vapeur dans la chambre étant dans la plage de 1 à plusieurs dizaines de milli-Torr, pendant une période temporelle suffisante pour que la couche de composé métallique soit remplacée par une couche d'oxyde métallique;
les étapes (a) et (b) étant répétées jusqu'à ce que la couche d'isolation ainsi formée atteigne une épaisseur souhaitée.

6. Procédé selon la revendication 5, comprenant en outre les étapes suivantes:
(c) transfert du substrat (W) dans la première position (32) et soumission du substrat à la vapeur d'un autre composé métallique, organique ou inorganique, qui peut réagir avec du H₂O et/ou de l'O₂ pour former un autre oxyde métallique à la condition d'écoulement moléculaire, la pression de vapeur dans la chambre de réaction (30) étant dans la plage de 1 à plusieurs dizaines de milli-Torr, pendant une période temporelle suffisante pour la formation de moins qu'une unique couche atomique du composé métallique supplémentaire ou de sensiblement celle-ci ; et
(d) transfert du substrat (W) dans la seconde position (33) et soumission de la surface de la couche de composé métallique supplémentaire formée au niveau de l'étape (c) au second gaz qui est de la vapeur de H₂O et/ou de gaz O₂ moyennant la condition d'écoulement moléculaire, la pression de vapeur dans la chambre de réaction (30) étant dans la plage de 1 à plusieurs dizaines de milli-Torr pendant une période temporelle qui suffit pour que la couche de composé métallique supplémentaire soit remplacée par une couche d'oxyde métallique supplémentaire ;
les étapes (a), (b), (c) et (d) étant répétées jusqu'à ce que la couche d'isolation ainsi formée atteigne une épaisseur souhaitée.

7. Procédé selon la revendication 5 ou 6, dans lequel le composé métallique utilisé au niveau de l'étape (a) est choisi de manière à être un élément pris parmi:
(i) le chlorure d'aluminium, le bromure d'aluminium, le triméthylaluminium, le triéthylaluminium, le chlorure de diméthylaluminium, le chlorure de diéthylaluminium dans le cas où l'oxyde métallique prévu au niveau de l'étape (b) est de l'oxyde d'aluminium ;
ou parmi :
(ii) le chlorure de titane, le bromure de titane dans le cas où l'oxyde métallique prévu au niveau de l'étape (b) est de l'oxyde de titane.

8. Procédé selon la revendication 5, 6 ou 7, dans lequel le dispositif d'affichage matriciel actif comporte des premier et second substrats formant une enceinte, une pluralité d'éléments d'affichage agencés selon des rangées et des colonnes, chaque élément d'affichage comprenant des première et seconde électrodes transparentes formées respectivement sur des surfaces intérieures des premier et second substrats et un matériau influençant la lumière situé entre, une pluralité de transistors à film mince formés sur le premier substrat en des positions correspondant à celles des éléments d'affichage et comportant chacun une électrode de grille, une couche d'isolation de grille, une couche semiconductrice et des électrodes de source et de drain et au moins des lignes de bus de grille formées sur le premier substrat pour commander les éléments d'affichage par l'intermédiaire des transistors à film mince, la ligne de bus de grille connectant les électrodes de grille situées suivant la direction de rangée.

9. Procédé selon la revendication 8, dans lequel la couche d'isolation ainsi formée est une couche d'isolation de grille d'un transistor à film mince.

10. Procédé selon la revendication 8 ou 9, dans lequel le dispositif d'affichage matriciel actif comprend en outre des lignes de bus de source/drain connectant une pluralité d'électrodes de source/drain suivant la direction de colonne et formées sur le premier substrat.

11. Procédé selon la revendication 8, 9 ou 10, comprenant en outre :
la formation de l'électrode de grille en matériau conducteur sur le premier substrat avant la formation de ladite couche d'isolation de grille ; et
le dépôt d'une couche semiconductrice en silicium amorphe sur ladite couche d'isolation de grille au moyen d'un procédé CVD plasma.

12. Procédé selon la revendication 8, 9, 10 ou 11, comprenant en outre :
le dépôt d'une seconde couche d'isolation de grille en nitrure de silicium sur ladite couche d'isolation de grille au moyen d'un procédé CVD plasma.

13. Procédé selon la revendication 8, le dispositif comprenant en outre des lignes de bus de source/drain formées sur le premier substrat, les lignes de bus de source/drain connectant des électrodes de source/drain suivant la direction de colonne et les lignes de bus de grille et de source/drain étant isolées les unes des autres par une couche d'isolation interligne de bus au niveau de chaque intersection de ces lignes, dans lequel la couche d'isolation ainsi formée est une couche d'isolation interligne de bus.

14. Procédé selon la revendication 13, dans lequel une seconde couche d'isolation interligne de bus en nitrure de silicium est déposée au moyen d'un procédé CVD plasma sur la couche d'isolation ainsi formée avant que les lignes de bus de source/drain ne soient formées.

15. Procédé selon la revendication 13 ou 14, dans lequel la couche d'isolation ainsi formée joue le rôle de couche d'isolation interligne de bus et de couche d'isolation de grille.

16. Procédé selon la revendication 8, le dispositif comprenant en outre une couche de protection, au moins sur une région de transistor à film mince du dispositif, dans lequel la couche ainsi formée est la couche de protection.

17. Procédé selon la revendication 8, le dispositif d'affichage comprenant en outre des capacités auxiliaires correspondant à des éléments d'affichage respectifs, chacune étant formée par une première électrode transparente et par une autre électrode auxiliaire formée sur le premier substrat, comportant une couche d'isolation de capacité entre elles, le procédé comprenant la formation de l'électrode auxiliaire sur le premier substrat; la fourniture de la couche d'isolation ainsi formée en tant qu'isolation de capacité sur l'électrode auxiliaire et la formation de la première électrode transparente sur la couche d'isolation de capacité.
